# FASCICULE DE BREVET EUROPEEN

(11) **EP 0 741 369 B1**
(45) Date de publication et mention de la délivrance du brevet: **03.07.2002**
(21) Numéro de dépôt: 96106250.2
(22) Date de dépôt: 20.04.1996
(51) Int. Cl.: G06K 19/077

(54) **Procédé d'enrobage d'un composant électronique et dispositif de mise en oeuvre dudit procédé**
Verfahren zur Umhüllung eines elektronischen Bauelements und Vorrichtung zur Ausführung des Verfahrens
Method for coating an electronic component and device for carrying out the method

(30) Priorité: 05.05.1995 FR 9505503
(43) Date de publication de la demande: 06.11.1996
(73) Titulaire: SCHLUMBERGER Systèmes, 92120 Montrouge (FR)
(72) Inventeur: Munch, Roger, 28170 Chateauneuf en Thymerais (FR)
(74) Mandataire: Lemoyne, Didier

(56) Documents cités:
- FR-A- 2 670 930
- PATENT ABSTRACTS OF JAPAN vol. 12, no. 167 (E-610), 19 Mai 1988 & JP-A-62 276839 (HIRACHI LTD), 1 Décembre 1987,

## Description

La présente invention concerne un procédé d'enrobage d'un composant électronique comprenant au moins une pastille semi-conductrice disposée sur un film isolant. Elle concerne également un dispositif de mise en oeuvre dudit procédé.

L'invention trouve une application particulièrement avantageuse dans le domaine des modules électroniques destinés aux cartes à mémoire, qu'il s'agisse de cartes dont le composant est un microprocesseur comme dans le cas des transactions bancaires et de la téléphonie mobile, ou encore une mémoire EEPROM comme dans les télécartes utilisées en publiphonie.

Une technique habituellement utilisée pour réaliser des modules électroniques de cartes à mémoire est de disposer une pastille semi-conductrice, ou puce, sur un film isolant, soit directement à la surface du film, soit dans une fenêtre préalablement découpée dans l'épaisseur dudit film isolant. Dans tous les cas, le film porte des contacts électriques auxquels la pastille semi-conductrice est reliée par des fils de connexion passant à travers des perforations ménagées dans le film isolant. Ces contacts électriques sont destinés à assurer la liaison électrique avec un appareil, tel qu'un lecteur de cartes, avec lequel ladite pastille semi-conductrice doit échanger des informations.

L'ensemble de la pastille semi-conductrice et des fils de connexion constitue un composant électronique qu'il faut impérativement protéger tant du point de vue chimique, contre les agressions extérieures comme la corrosion, que du point de vue mécanique du fait notamment de l'extrême fragilité des fils de connexion.

De manière générale, la protection recherchée pour les composants électroniques est obtenue par enrobage de la pastille semi-conductrice et des fils de connexion à l'aide d'une résine liquide thermodurcissable.

Deux procédés d'enrobage sont actuellement utilisés.

Selon un premier procédé connu, une goutte de résine à haute viscosité est déposée sur le composant. Puis, après polymérisation de la résine, la goutte durcie est arasée par usinage, afin de donner au composant final la cote en épaisseur désirée.

Selon un deuxième procédé connu, la résine est moulée directement autour du composant électronique.

Toutefois, ces deux techniques d'enrobage présentent de sérieux inconvénients.

La première nécessite deux opérations, à savoir l'enrobage proprement dit et l'usinage à la cote. De plus, l'utilisation d'une résine à haute viscosité pour éviter l'étalement exige, surtout pour de grosses pastilles comme les microprocesseurs, des équipements de dépôt complexes avec mouvements dans les trois axes qui réduisent les cadences de manière pénalisante.

La seconde technique de moulage est lourde à mettre en oeuvre, il faut en effet manipuler des moules, des presses, etc.

Par ailleurs, le document FR-A-2 670 930 reflète le préambule de la revendication 1, et décrit un procédé de réalisation d'un module électronique d'un objet portatif tel qu'une carte à microcircuits selon lequel un anneau, éventuellement interrompu, délimite l'étalement de la résine.

Aussi le problème technique à résoudre par l'objet de la présente invention est de proposer un procédé d'enrobage d'un composant électronique comprenant au moins une pastille semi-conductrice disposée sur un film isolant portant des contacts électriques auxquels ladite pastille semi-conductrice est reliée par des fils de connexion passant à travers des perforations ménagées dans ledit film isolant, procédé qui permettrait d'obtenir, en une seule opération d'enrobage, à la fois une bonne protection du composant et la cote en épaisseur recherchée sans avoir recours à un quelconque usinage ou moulage.

Le problème technique posé est résolu, selon la présente invention, du fait que ledit procédé comprend les étapes consistant à :
- réaliser des perforations dans le film isolant autour d'une zone prévue pour recevoir la pastille semi-conductrice, lesdites perforations étant au moins en partie destinées au passage des fils de connexion du composant électronique,
- disposer la pastille semi-conductrice sur le film isolant dans ladite zone,
- connecter lesdits fils de connexion entre la pastille semi-conductrice et les contacts électriques au travers des perforations,
- déposer une goutte de résine sur la pastille semi-conductrice et les fils de connexion, l'étalement de la goutte étant limité, et même contrôlé, par les forces de tensions superficielles créées sur ladite goutte au niveau des perforations, ladite goutte présentant un contour défini par les seules perforations.

Ainsi, le procédé de l'invention repose sur l'utilisation de l'effet des tensions superficielles au niveau des perforations pratiquées dans le support isolant pour éviter l'étalement de la goutte de résine. Celle-ci peut alors avoir une viscosité beaucoup plus faible ce qui en facilite la manipulation et permet d'obtenir les épaisseurs voulues sans opération d'usinage ni équipements complexes de dépôt, il suffit pour cela d'avoir des gouttes de résine calibrées au départ.

C'est dans ce but que l'invention prévoit également un dispositif de mise en oeuvre du procédé d'enrobage conforme à l'invention, remarquable en ce qu'il comporte :
- un distributeur apte à fournir à travers un tuyau souple d'alimentation des gouttes de résine calibrées en volume,
- une tête d'enrobage reliée au distributeur par ledit tuyau souple d'alimentation, et comportant une chambre d'enrobage apte à recevoir lesdites gouttes de résine calibrées en volume, ladite chambre d'enrobage présentant un contour prévu pour recouvrir au moins partiellement lesdites perforations.

La description qui va suivre en regard des dessins annexés, donnés à titre d'exemples non limitatifs, fera bien comprendre en quoi consiste l'invention et comment elle peut être réalisée.

La figure 1a est une vue de dessus d'un premier composant électronique enrobé selon le procédé conforme à l'invention.

La figure 1b est une vue de face en coupe selon la ligne II-II de la figure 1a.

La figure 2a est une vue de dessus d'un deuxième composant électronique enrobé selon le procédé conforme à l'invention.

La figure 2b est une vue de face en coupe selon la ligne III-III de la figure 2a.

La figure 3a est une vue de face en coupe montrant le composant de la figure 1b et un dispositif d'enrobage conforme à l'invention.

La figure 3b est une vue de côté correspondant à la figure 3a.

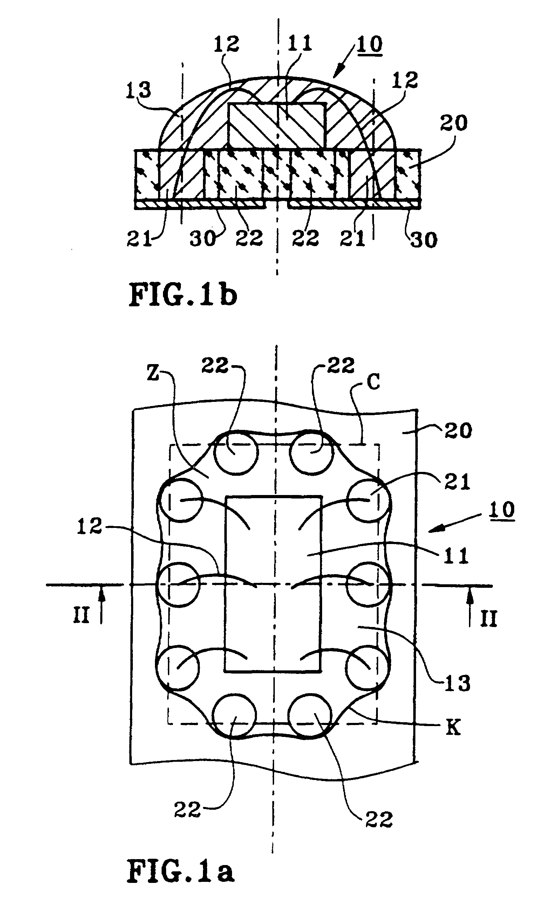

Sur les figures 1a et 1b est représenté un composant électronique 10 comprenant une pastille semi-conductrice 11, microprocesseur ou mémoire EEPROM par exemple, disposée sur une face d'un film isolant 20 se présentant sous forme d'une bande en matière plastique.

Comme l'indique plus précisément la figure 1b, le film isolant 20 porte sur une autre de ses faces des contacts électriques 30 prévus pour réaliser une liaison électrique entre un lecteur non représenté, et la pastille semi-conductrice. Pour cela, ladite pastille semi-conductrice 11 est reliée auxdits contacts électriques 30 par des fils 12 de connexion, fils d'or par exemple. Les figures 1a et 1b montrent clairement que lesdits fils 12 de connexion traversent des perforations 21 ménagées dans le film isolant 20.

Pour enrober le composant électronique 10, formé de la pastille semi-conductrice 11 et des fils 12 de connexion, d'une enveloppe protectrice, on utilise le procédé suivant.

On réalise, d'abord, des perforations 21, 22 dans le film isolant 20 autour d'une zone Z prévue pour recevoir la pastille semi-conductrice 11, les perforations 21 étant destinées au passage des fils 12 de connexion du composant 10 et les perforations 22 étant des perforations complémentaires.

Puis, la pastille semi-conductrice 11 est collée à la surface du film 20 dans la zone Z prévue à cet effet, les fils 12 de connexion étant ensuite connectés entre la pastille semi-conductrice 11 et les contacts électriques 30 dont le film isolant 20 est préalablement revêtu.

Enfin, une goutte 13 de résine thermodurcissable liquide, de faible viscosité, est déposée sur le composant électronique 10 de manière à enrober complètement la pastille semi-conductrice 11 et les fils 12 de connexion et à remplir les perforations 21, 22. Comme on peut le voir sur la figure la, le contour K de la goutte 13 recouvre exactement lesdites perforations. L'étalement de la goutte 13 de résine est limité, et même contrôlé, par les forces de tensions superficielles créées sur la goutte 13 au niveau des perforations 21, 22. On comprend dans ces conditions que, si le volume de ladite goutte 13 est parfaitement calibré, on puisse obtenir finalement une goutte de forme reproductible, présentant notamment une cote en épaisseur bien déterminée, sans qu'il y ait besoin de l'ajuster par un usinage ultérieur.

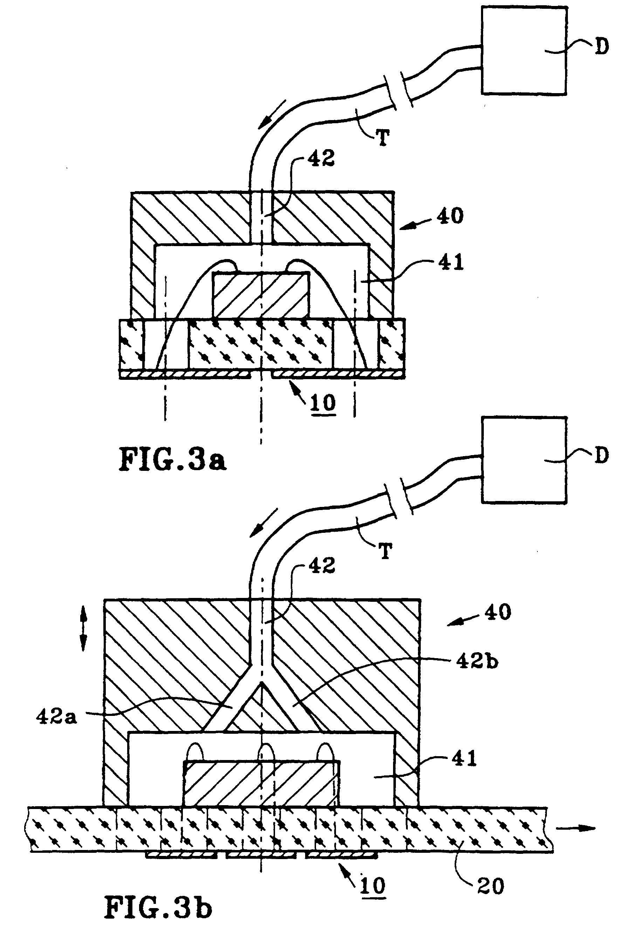

Pour réaliser cet enrobage, on utilise un dispositif représenté sur les figures 3a et 3b comprenant un distributeur D contenant une résine liquide, époxy ou acrylique, de faible viscosité. Le distributeur D fournit à travers un tuyau souple T d'alimentation des gouttes de résine calibrées en volume.

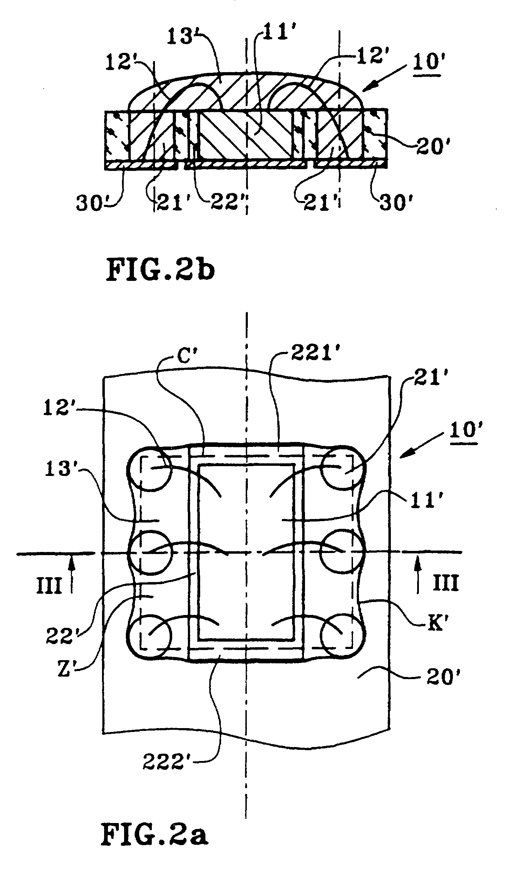

Une tête 40 d'enrobage est reliée au distributeur D par ledit tuyau souple T d'alimentation et comporte une chambre 41 d'enrobage apte à recevoir les gouttes de résine calibrées en volume. Ladite chambre 41 doit donc avoir un volume égal à celui des gouttes de résine, et, d'autre part, afin de pouvoir remplir les perforations 21, 22 sans étalement, le contour C de la chambre d'enrobage doit recouvrir partiellement lesdites perforations, ainsi que le montre la figure la de même que la figure 2a quant au contour C' de la chambre 41 dans le cas d'un autre type de composant électronique qui sera décrit plus loin.

Sur les figures 3a et 3b, on voit que le canal d'injection de la résine dans la chambre 41 d'enrobage peut avoir plusieurs formes possibles : une simple forme droite 42 comme sur la figure 3a ou une première forme droite 42 suivie d'un dédoublement en deux branches 42a, 42b en Y comme sur la figure 3b.

Cette dernière figure montre également que le dispositif décrit ci-dessus se prête bien à l'automatisation de l'opération d'enrobage des composants électriques.

La tête 40 d'enrobage est placée à poste fixe sur le trajet de défilement du film isolant 20 en bande. A chaque fois qu'un composant passe devant la tête d'enrobage, la bande s'arrête et la tête 40 vient en position sur le composant électronique 10 tandis qu'une goutte de résine est injectée dans la chambre 41 d'enrobage. Après injection, la tête 40 d'enrobage est dégagée et la bande avance jusqu'à présenter le composant suivant à la tête d'enrobage.

Dans le mode de réalisation illustré aux figures 2a et 2b, le composant électronique 10' comprend une pastille semi-conductrice 11', disposée dans une fenêtre 22' ménagée dans le film isolant 20'.

Ladite pastille semi-conductrice 11' est reliée aux contacts électriques 30' par des fils 12' de connexion traversant des perforations 21' réalisées autour de la zone Z' du film 20' dans laquelle est découpée la fenêtre 22'. Comme le montre la figure 2a, le contour C' de la chambre d'enrobage recouvre dans ce cas partiellement les perforation 21' et deux flancs 221', 222' complémentaires de la fenêtre 22', le contour K' de la goutte 13' ainsi déposée recouvrant lesdites perforations 21' et les deux flancs 221', 222'.

## Revendications

1. Procédé d'enrobage d'un composant électronique (10 ; 10') comprenant au moins une pastille semi-conductrice (11 ; 11') disposée sur un film isolant (20 ; 20') portant des contacts électriques (30 ; 30') auxquels ladite pastille semi-conductrice est reliée par des fils (12 ; 12') de connexion passant à travers des perforations (21 ; 21') ménagées dans ledit film isolant (20 ; 20'), ledit procédé comprenant les étapes consistant à :
- réaliser lesdites perforations (21 ; 21") dans le film isolant (20 ; 20') autour d'une zone (Z ; Z') prévue pour recevoir la pastille semi-conductrice (11 ; 11'),
- disposer la pastille semi-conductrice sur le film isolant dans ladite zone (Z ; Z'),
- connecter lesdits fils (12 ; 12') de connexion entre la pastille semi-conductrice (11 ; 11') et les contacts électriques (30 ; 30') au travers des perforations (21 ; 21'),
- déposer une goutte (13 ; 13') de résine sur la pastille semi-conductrice et les fils de connexion,
**caractérisé en ce que** l'étalement de la goutte (13, 13') est limité, et même contrôlé, par les forces de tensions superficielles créées sur ladite goutte (13, 13') au niveau des perforations (21, 22 ; 21', 22'), ladite goutte (13, 13') présentant un contour (K ; K') défini par les seules perforations (21, 22 ; 21', 22').

2. Procédé d'enrobage selon la revendication 1, **caractérisé en ce que** ladite résine est une résine thermodurcissable liquide.

3. Procédé d'enrobage selon la revendication 2, **caractérisé en ce que** la résine est de faible viscosité, par exemple epoxy ou acrylique.

4. Procédé d'enrobage selon l'une des revendications 1, 2 ou 3, **caractérisé en ce qu'**il comprend en outre l'étape consistant à réaliser des perforations complémentaires (22), identiques auxdites perforations (21).

5. Procédé d'enrobage selon la revendication 4, **caractérisé en ce que** les perforations complémentaires (22) sont réalisées autour de la zone (Z) prévue pour recevoir la pastille semi-conductrice (11).

6. Procédé d'enrobage selon l'une des revendications 1 ou 2, **caractérisé en ce que**, ladite pastille semi-conductrice (11') étant disposée dans une fenêtre (22') ménagée dans le film isolant (20'), lesdites perforations sont disposées à l'extérieur de ladite fenêtre (22').

7. Dispositif de mise en oeuvre du procédé d'enrobage selon l'une quelconque des revendications 1 à 6, **caractérisé en ce qu'**il comporte
- un distributeur (D) apte à fournir à travers un tuyau souple (T) d'alimentation des gouttes de résine calibrées en volume,
- une tête d'enrobage (40) reliée au distributeur (D) par ledit tuyau souple (T) d'alimentation, et comportant une chambre (41) d'enrobage apte à recevoir lesdites gouttes de résine calibrées en volume, ladite chambre (41) d'enrobage présentant un contour (C ; C') prévu pour recouvrir au moins partiellement lesdites perforations (21, 22 ; 21', 22').

## Patentansprüche

1. Beschichtungsverfahren einer elektronischen Komponente (10 ; 10'), bestehend aus mindestens einem Halbleiterchip (11 ; 11') auf einem Isolierfilm (20 ; 20') als Träger elektrischer Kontakte (30 ; 30'), mit welchen besagter Halbleiterchip über Anschlussdrähte (12 ; 12') verbunden ist, welche im besagten Isolierfilm (20 ; 20') vorgesehene Lochungen (21 ; 21') durchlaufen, wobei besagtes Verfahren aus den Schritten besteht, welche:
- besagte Lochungen (21 ; 21') im Isolierfilm (20 ; 20') um einen Bereich (Z ; Z') zur Aufnahme des Halbleiterchips (11 ; 11') ausführen,
- den Halbleiterchip auf dem Isolierfilm in besagtem Bereich (Z ; Z') aufbringen,
- besagte Anschlussdrähte (12 ; 12') zwischen dem Halbleiterchip (11 ; 11') und den elektrischen Kontakten (30 ; 30') mit Hilfe von Lochungen (21 ; 21') verbinden,
- einen Harztropfen (13 ; 13') auf den Halbleiterchip und die Anschlussdrähte auftragen,
**dadurch gekennzeichnet, dass** das Verlaufen des Tropfens (13, 13') in Grenzen bleibt und sogar durch die auf besagtem Tropfen (13, 13') an den Lochungen (21, 22 ; 21', 22') entstehenden Oberflächenspannungskräfte kontrolliert wird, wobei besagter Tropfen (13, 13') einen ausschliesslich durch die Lochungen (21, 22 ; 21', 22') definierten Umkreis darstellt.

2. Beschichtungsverfahren gemäss Patentanspruch 1, **dadurch gekennzeichnet, dass** besagtes Harz ein hitzehärtbares Flüssigharz niedriger Viskosität ist.

3. Beschichtungsverfahren gemäss Patentanspruch 2, **dadurch gekennzeichnet, dass** das Harz eine niedrige Viskosität hat, z.B. Epoxyoder Acrylharz.

4. Beschichtungsverfahren gemäss Patentanspruch 1, 2 oder 3, **dadurch gekennzeichnet, dass** es zusätzlich den Schritt umfasst, welcher in der Ausführung der ergänzenden Lochungen (22), welche identisch mit besagten Lochungen (21) sind, besteht.

5. Beschichtungsverfahren gemäss Patentanspruch 4, **dadurch gekennzeichnet, dass** die ergänzenden Lochungen (22) um den Bereich (Z) zur Aufnahme des Halbleiterchips (11) ausgeführt sind.

6. Beschichtungsverfahren gemäss einer der Patentansprüche 1 oder 2, **dadurch gekennzeichnet, dass** besagter Halbleiterchip (11') in einem im Isolierfilm (20') vorgesehenen Fenster (22') aufgebracht ist, wobei besagte Lochungen ausserhalb besagten Fensters (22') vorgesehen sind.

7. Vorrichtung zur Verwirklichung des Beschichtungsverfahrens gemäss einem beliebigen Patenanspruch 1 bis 6, **dadurch gekennzeichnet, dass** er folgende Ausrüstung enthält:
- einen Verteiler (D), welcher über einen Versorgungsschlauch (T) volumenkalibrierte Harztropfen führen kann
- einen Beschichtungskopf (40), welcher über besagten Versorgungsschlauch (T) mit dem Verteiler (D) verbunden ist und eine Beschichtungskammer (41) zur Aufnahme besagter volumenkalibrierter Harztropfen enthält, wobei besagte Beschichtungskammer (41) einen Umkreis (C ; C') aufweist, um besagte Lochungen (21, 22 ; 21', 22') mindestens teilweise abzudecken.

## Claims

1. A method of coating an electronic component (10; 10') comprising at least one semiconductor chip (11; 11') placed on an insulating film (20; 20') carrying electric contacts (30; 30') to which said semiconductor chip is connected by connection wires (12; 12') passing through holes (21; 21') formed in said insulating film (20; 20'), the said method comprising the following steps:
- making said holes (21, 21') in the insulating film (20; 20') around a zone (Z; Z') for receiving the semiconductor chip (11; 11'),
- placing the semiconductor chip on the insulating film in said zone (Z; Z'),
- connecting said connection wires (12; 12') between the semiconductor chip (11; 11') and the electric contacts (30; 30') through the holes (21; 21'),
- depositing a drop of resin (13; 13') on the semiconductor chip and on the connection wires,
wherein the spreading of the drop (13; 13') is restricted and even controlled by the surface tension forces created on the said drop (13, 13') at the holes (21, 22; 21', 22'), the said drop (13, 13') presenting an outline (K; K') defined solely by the holes (21, 22; 21', 22').

2. A coating method according to claim 1, wherein the said resin is a liquid thermosetting resin.

3. A coating method according to claim 2, wherein a low viscosity resin, e.g. epoxy or acrylic, is used.

4. A coating method according to claim 1, 2 or 3, wherein it also includes the step which consists of making supernumerary holes (22), identical to said holes (21).

5. A coating method according to claim (4) wherein the supernumerary holes (22) are made around the zone (Z) for receiving the semiconductor chip (11).

6. A coating method according to claim 1 or 2, wherein said semiconductor chip (11') is placed in a window (22') formed in the insulating film (20'), and said holes are located outside said window (22').

7. Apparatus for implementing the coating method according to any of claims 1 to 6, comprising:
- a dispenser (D) suitable for delivering volume-calibrated drops of resin via a flexible feed hose (T), and
- a coating head (40) connected to the dispenser (D) by said flexible feed hose (T), and including a coating chamber (41) suitable for receiving said drops of volume-calibrated resin, said coating chamber (41) having an outline (C; C') designed to cover said holes at least in part (21, 22; 21', 22').
